(19) **Europäisches Patentamt / European Patent Office / Office européen des brevets**

(11) **EP 1 601 109 B1**

(12) **EUROPEAN PATENT SPECIFICATION**

(45) Date of publication and mention
of the grant of the patent:
**21.04.2010 Bulletin 2010/16**

(51) Int Cl.:
***H03M 13/29*** *(2006.01)*

(21) Application number: **05016017.5**

(22) Date of filing: **30.07.1998**

(54) **Adaptive channel encoding method and device**

Verfahren und Vorrichtung zur adaptiven Kanalcodierung

Méthode et appareil de codage canal adaptifs

(84) Designated Contracting States:
**DE ES FI FR GB IT SE**

(30) Priority: **30.07.1997 KR 9736265**
**10.11.1997 KR 9760101**

(43) Date of publication of application:
**30.11.2005 Bulletin 2005/48**

(62) Document number(s) of the earlier application(s) in
accordance with Art. 76 EPC:
**98935383.4 / 0 997 031**

(73) Proprietor: **SAMSUNG ELECTRONICS CO., LTD.**
**Suwon-shi**
**Kyonggi do 442-270 (KR)**

(72) Inventors:
• **Park, Chang Soo**
**Seoul 134-023 (KR)**
• **Lee, Hyeon Woo**
**Suwon-shi**
**Kyonggi-do 441-390 (KR)**
• **Lee, Pil Joong**
**Seoul 121-220 (KR)**
• **Kong, Jun Jin**
**Songnam-shi**
**Kyonggi-do 461-162 (KR)**
• **Kim, Yong**
**Seoul 157-012 (KR)**

(74) Representative: **Grünecker, Kinkeldey,**
**Stockmair & Schwanhäusser**
**Anwaltssozietät**
**Leopoldstrasse 4**
**80802 München (DE)**

(56) References cited:
• **DIVSALAR D ET AL: "Turbo Codes for Deep-Space Commuications" TDA PROGRESS REPORT, vol. 42-120, 15 February 1995 (1995-02-15), pages 29-39, XP002317264**
• **BOMER L ET AL: "A CDMA radio link with 'turbo-decoding': concept and performance evaluation" SIXTH IEEE SYMPOSIUM ON PERSONAL, INDOOR AND MOBILE RADIO COMMUNICATIONS, PIMRC'95, vol. 2, 27 September 1995 (1995-09-27), - 29 September 1995 (1995-09-29) pages 788-793, XP010150891 ISBN: 0-7803-3002-1**
• **BARBULESCU A S ET AL: "Rate compatible turbo codes" ELECTRONICS LETTERS, IEE STEVENAGE, GB, vol. 31, no. 7, 30 March 1995 (1995-03-30), pages 535-536, XP006002664 ISSN: 0013-5194**
• **BERROU C ET AL: "Near Shannon limit error-correcting coding and decoding: Turbo-codes. 1" PROCEEDINGS OF THE INTERNATIONAL CONFERENCE ON COMMUNICATIONS (ICC). GENEVA, MAY 23 - 26, 1993, NEW YORK, IEEE, US, vol. VOL. 3, 23 May 1993 (1993-05-23), pages 1064-1070, XP010137024 ISBN: 0-7803-0950-2**

**Description**

## BACKGROUND OF THE INVENTION

1. Field of the Invention

The present invention relates to adaptive channel encoding methods and devices for communications systems, and in particular, to adaptive channel encoding methods and devices for use in transmission of voice and data.

2. Description of the Related Art

A turbo encoder, constituted in a parallel or serial structure, generates parity symbols from an input N-information bit frame with two simple component (or constituent) encoders. It uses a recursive systematic convolutional (RSC) code as a component (or constituent) code.

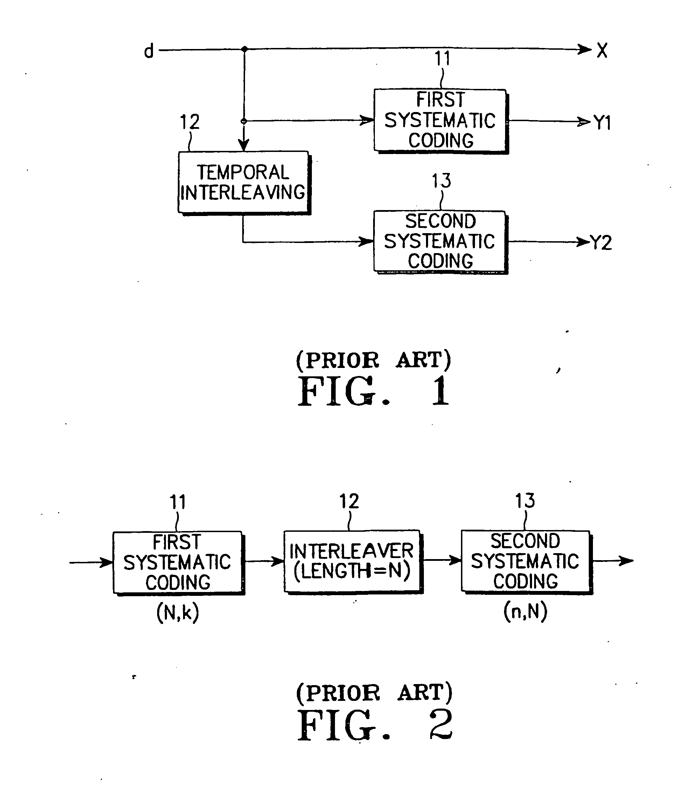

FIG. 1 is a block diagram of a conventional parallel turbo encoder, disclosed in U.S. Patent No. 5,446,747 by Berrou. In the turbo encoder of FIG. 1, an interleaver 12 is interposed between first and second component encoders 11 and 13. The interleaver 12 has a size equivalent to the frame length N of the input information bits, and modifies the sequence of information bits received in the second component encoder 13 to reduce correlation between information bits. FIG. 2 is a block diagram of a conventional serial turbo encoder also having the interleaver 12 connected between the first and second component encoders 11 and 13.

The above turbo encoders produce a turbo code for use in space communications. Though a constraint length K in the component encoders 11 and 13 is shorter than that of a conventional convolutional code (i.e., K=9), the interleaver 12 uses a very large memory, resulting in a very long delay at decoding.

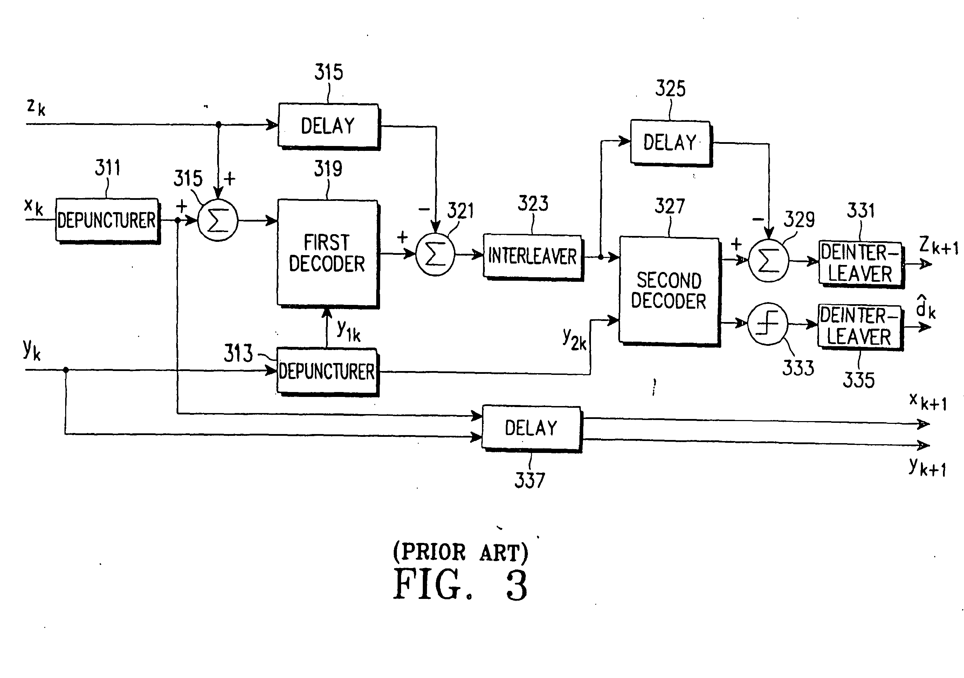

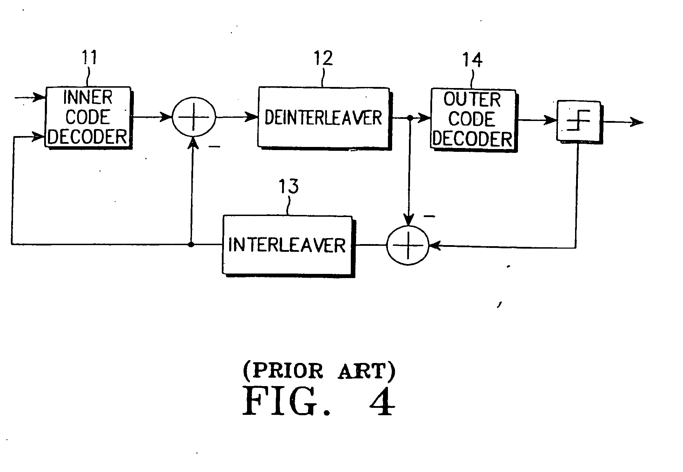

FIG. 3 is a block diagram of a turbo decoder for decoding the output of the parallel turbo encoder shown in FIG. 1, also disclosed in U.S. Patent No. 5,446,747 by Berrou. FIG. 4 is a block diagram of a turbo decoder for decoding the output of the serial turbo encoder shown in FIG. 2, proposed by Benedetto in an article of IEEE Electronics Letters, Vol. 32, No. 13, June 1996.

The parallel turbo decoder of FIG. 3 advantageously enhances performance characteristics in terms of bit error rate (BER) by repeatedly decoding input data in frame units, using an iterative decoding algorithm. An interleaver 323 contributes to an increase in an error correction capability by distributing burst error patterns which were not corrected by a first decoder 319, prior to correction of the burst error patterns in a second decoder 327.

The iterative decoding refers to repeated decoding of symbols which were decoded in a specific procedure, using resulting extrinsic information, to achieve excellent decoding performance. Iterative decoding algorithms are SOVA (Soft-Output Viterbi Algorithm: see Proceedings of IEEE Vehicular Technology Conference, pp. 941-944, May 1993) and MAP (Maximum Aposteriori Probability: see IEEE Transactions on Information Theory, pp. 429-445, Vol. 42, No. 2, March 1996). SOVA is a modification of a Viterbi algorithm which produces a soft decision output and can minimize codeword error rate. On the other hand, MAP can minimize symbol error rate.

In the decoder of FIG. 3, outputs $y_{1k}$ and $y_{2k}$ of a depuncturer 313 are $y_k$ and zero, respectively, when a parity symbol $y_k$ is received from the first component encoder 11 of FIG. 1, whereas they are zero and $y_k$, respectively, when the parity symbol $y_k$ is received from the second component encoder 13 of FIG. 1. $Z_{k+1}$ is a soft decision symbol used as extrinsic information in an iterative decoding algorithm and an input for decoding in a next stage. A final intended symbol is obtained by subjecting $Z_{k+1}$ to hard decision. The performance of the turbo code depends on interleaver size, interleaver structure, and the number of iterative decodings.

As shown in FIG. 1, the turbo encoder includes the interleaver 12. The interleaver 12 causes turbo encoding/decoding to be implemented in frame units. Thus, the complexity of turbo code is proportional to the product of frame size of a memory necessary for first and second iterative decoders 319 and 327 shown in FIG. 3 and the state number of component codes for the first and second component encoders 11 and 13. The turbo code cannot find its application in voice and data transmission due to use of very large frames. Increasing the state number of the component codes for the turbo encoder in order to achieve better performance leads to increased complexity of the first and second component encoders 11 and 13.

With a burst error in the decoder as shown in FIG. 3, the output of the first iterative decoder 319 has a correlation, which impedes reliable decoding in the second iterative decoder 327 in the next decoding stage. Hence, errors are incurred in a whole block and cannot be corrected in a next iterative decoding stage. In this context, there is an ever increasing need for an interleaver and a deinterleaver which can distribute burst errors in a single frame of a code subject to iterative decoding without correlation.

Due to the advantage of low correlation, a random interleaver increases the performance of the turbo code. With small frame size, however, the random interleaver has limitations in its effectiveness for distributing burst errors without correlation and requires a look-up table. Hence, voice transmission or low-rate data transmission require small frame size and a small number of component code states to minimize delay time. Voice transmission or low-rate data transmission further need a structured interleaver. In short, the conventional turbo code is not viable in the voice and data transmission because of the unacceptability of the constraint length of the component codes and the large interleaver. Nevertheless, efforts are increasingly expended on realization of an encoder and a decoder for a communications system, taking the advantages of the conventional turbo code into account.

Therefore, a need exists for a turbo encoder having a performance equal to or higher than that of a convolutional encoder in a conventional communications system. A further need exists for an interleaver having excellent performance with small component code states and minimized delay time. Though the performance of the interleaver 12 of FIG. 1 or 2 for use in a turbo encoder is generally proportional to the interleaver size, the frame size of the turbo code is limited. In this case, it is preferable to use an interleaver that maximizes a minimum hamming distance of the turbo code in terms of a block code. A structured interleaver can be employed for small frames.

Divsalar, D., et al. "Turbo Codes for Deep-Space Communications", TDA Progress Report, Volume 42-120, February 15, 1995, pages 29-39, in particular refers to a parallel concatenation of two convolutional code and the problem of trellis termination. A particular termination method that can be used for unequal rates and encoders are described. According to this termination method, a switch is provided which is in a first position for first N clock cycles and in a second position for M additional cycles. Those M additional cycles will flush the encoders with zeros.

Bomer, L., et al.: "A CDMA Radio Link with 'Turbo-Decoding': Concept and Performance Evaluation", 6th IEEE symposium and personal, indoor and mobile radio communications PIMRC'1995 Volume 2, September 27, 1995, pages 788-793, describes a CDMA radio link according to which speech and data services can be transmitted. The corresponding transmission parameters are given and a CDMA link is simulated for speech service and data service. It is in particular outlined by this reference that a single multi-dimensional code with turbo decoding may be used advantageously for data and speech services.

Barbulescu, A.S., et al.: "Rate Compatible Turbo Codes", Electronic Letters, IEE Stevenage, March 30, 1995, GB, Volume 31, No. 7, pages 535-536, discloses in particular multi-dimensional turbo codes where the rate can be varied from half to 1/n where n corresponds to the dimension of the code. Unequal error protection and corresponding turbo codes are disclosed to be used in transmission of compressed images or speed also mobile satellite channels.

Berrou, C., et al.: "Near Shannon Limit Error - Correcting Coding and Decoding: Turbo-Codes (1)", Proceedings of The International Conference on Communications (ICC) Geneva, May 23-26, 1993, Vol. 3, pages 1064-1070, discloses basics of turbo codes and in particular refers to the parallel concatenation of two recursive systematic convolutional codes with respect to an encoder and is said that the associated decoder uses a feedback decoding rule.

## SUMMARY OF THE INVENTION

It is an object of the present invention to provide turbo encoding method and devise, which can encode voice and low-transmission radio-datain a communication system wherein tail bits and parity bits generated from the tail bit are transmitted on a channel for encoding voice and data signals to a turbo code.

This object is solved by the features of the independent claims.

Advantageous embodiments are disclosed by the sub-claims.

For the interleaving different methods are possible.

A diagonal interleaving method may comprise the steps of receiving a frame size signal; determining column and row values corresponding to the size of an input frame; and diagonally interleaving the information bits of the input frame according to the column and row values.

The diagonal interleaving may be implemented on the basis of

$$for\ (k = 0;\ k < M * N\text{-}1;\ k + + )$$

$$new\ addr\ [k] = (M - 1 - (k\ mod\ N) * N + (k\ mod\ N)$$

where M and N are the column and row values, MxN is the frame size, and k is an index, and *new addr* [] represents the new address of the diagonally interleaved information bits.

The diagonal interleaving may also be implemented on the basis of

$$for\ (j = 0;\ j < M;\ j++)$$

$$for\ (i = 0;\ i < N;\ i + +\ )$$

$$new\ addr\ [\ i + j + N] = i + (M - 1 - 1\ (i + j)\ mod\ M)\ *N$$

where M and N are the column and row values, MxN is the frame size, and i and j are indexes and *new addr [ ]* represents the new address of the diagonally interleaved information bits.

Further, the diagonal interleaving may be implemented on the basis of

$$for\ (j = 0;\ j < M;\ j++)$$

$$for\ (i = 0;\ i < N;\ i + +\ )$$

$$new\ addr\ [\ i + j + N] = i + ((i + j)\ mod\ M)\ *\ N$$

where M and N are the column and row values, MxN is the frame size, and i and j are indexes and *new addr[]* represent the new address of the diagonally interleaved information bits.

A circular shifting interleaving method may compromise the steps of:

receiving a frame size signal;

determining hop and step parameters corresponding to the size of an input frame; and

performing a circular shifting interleaving on the information bits of the input frame according to the determined hop and step parameters, using the information bits as at least one circle.

The circular shifting interleaving may be implemented on the basis of

$$for\ (i = 0;\ i < SIZE;\ i + +\ )$$

$$new\ addr\ [i] = (p\ *\ i + STEP)\ mod\ SIZE$$

where SIZE is the size of data to be interleaved, p is the hop parameter for circular shifting interleaving, STEP is the step parameter having an integer value, for shifting data from a hopped position, *new addr []* represents the new address of the diagonally interleaved information bits and i is an index.

The circular shifting interleaving may also be implemented on the basis of

$$d = GCD\ (P,\ SIZE);\ for\ (k - j = 0;\ j < d;\ j + +\ )$$

$$for\ (i = 0;\ i < SIZE/d;\ i + +,\ k + +)$$

$$new\ addr\ [k] = ((P\ x\ i + STEP) + j)\ mod\ SIZE$$

where SIZE is the size of data to be interleaved, p is the hop parameter for circular shifting interleaving, STEP is the step parameter having an integer value, for shifting data from a hopped position, *new addr[]* represents the new address of the diagonally interleaved information bits, GCD is the greatest common denominator and i, k, and k are indexes.

A turbo encoder may comprise a plurality of component encoders for encoding input information bits; and a diagonal interleaver connected to an input port of one of the component encoders and having column and row information corresponding to sizes of input information, for determining column and row information corresponding to the frame size of the input information bits and diagonally interleaving the information bits.

A corresponding diagonal interleaver may comprise a diagonal interleaving table for storing the column and row information corresponding to sizes of input information; a diagonal interleaving of the information bits according to the column and row information, by

$$for\ (k\ =\ 0;\ k < M * N - 1;\ k + +)$$

$$new\ addr[k] = (M - 1 - (k\ mod\ N)) * N + (k\ mod\ N)$$

where M and N are the column and row information, k is an index *new addr[]* represents the new address of the diagonally interleaved information bits, and MxN is a frame size
or by

$$for\ (j = 0;\ j < M;\ j + +)$$

$$for\ (i = 0;\ i < N;\ i + +)$$

$$new\ addr\ [i + j + N] = i + (M - 1\ (i + j)\ mod\ M) * N$$

where M and N are the column and row information, *new addr[]* represents the new address of the diagonally interleaved information bits, and i and j are indexes,
or also by

$$for\ (j = 0;\ j < M;\ j + +)$$

$$for\ (i = 0;\ i < N;\ i + +)$$

$$new\ addr\ [i + j + N] = i + ((i + j)\ mod\ M) * N$$

where M and N are the column and row information, *new addr[]* represents the new address of the diagonally interleaved information bits, and i and j are indexes.

Such a turbo encoder may comprise a plurality of component encoders for encoding input information bits; and a circular shifting interleaver connected to an input port of one of the component encoders and having hop and step information corresponding to sizes of input information, for determining hop and step information corresponding to the frame size of the input information bits and performing a circular shifting interleaving on the information bits.

The circular shifting interleaver may comprise: a circular shifting interleaving table for storing the column and row information corresponding to sizes of an input frame; a circular shifting interleaving controller for generating addresses to be used in circular shifting interleaving of the information bits of the frame according to the hop and step information, by

$$for\ (i = 0;\ i < SIZE;\ i + +)$$

5

$$new\ addr[i] = (p * i + STEP)\ mod\ SIZE$$

where SIZE is the size of data to be interleaved, p is a hop parameter for circular shifting interleaving, *new addr[]* represents the new address of the diagonally interleaved information bits, STEP is a step parameter being an integer, for shifting data from a hopped position and i is an index,
or by

$$d = GCD\ (P,\ SIZE);\ for\ (k - j = 0;\ j < d;\ j + +)$$

$$for\ (i = 0;\ i < SIZE/d;\ i + +,\ k + +)$$

$$new\ addr[k] = ((P * i + STEP) + j)\ mod\ SIZE$$

where SIZE is the size of frame data to be interleaved, p is a hop parameter for circular shifting interleaving, and i, j, and k are indexes, *new addr[]* represents the new address of the diagonally interleaved information bits and STEP is a step parameter being an integer, for shifting data from a hopped position.

A circular shifting interleaving method may comprise the steps of: receiving a signal representative of input information size; determining a hop parameter corresponding to the input information size; and performing a circular shifting interleaving on the input information bits according to the determined hop parameter, using the information bits as at least one circle.

The circular shifting interleaving may be implemented on the basis of

$$for(i = 0;\ i < SIZE;\ i + +)$$

$$new\ addr[i] = (p * i + STEP)\ mod\ SIZE$$

where SIZE is the size of input information to be interleaved, p is the hop parameter for circular shifting interleaving, STEP is the step parameter having an integer value, for shifting data from a hopped position, *new addr[]* represent the new address of the diagonally interleaved information bits, and i is an index,
or on the basis of

$$d = GCD\ (P,\ SIZE);\ for\ (k - j = 0;\ j < d;\ j + +)$$

$$for\ (i = 0;\ i < SIZE/d;\ i + +,\ k + +)$$

$$new\ addr[k] = ((P * i + STEP) + j)\ mod\ SIZE$$

where SIZE is the size of input information to be interleaved, p is the hop parameter for circular shifting interleaving, *new addr[]* represents the new address of the diagonally interleaved information bits, GCD is a greatest common denominator, i, j and k are indexes and STEP is the step parameter having an integer value, for shifting data from a hopped position.

Generally, the circular shifting interleaving may be implemented according to a hop parameter corresponding to the size of the input information. The size of the input information and the hop parameter corresponding to the size of the input information may be stored.

The circular shifting interleaving may also be implemented according to a hop parameter corresponding to the size of the input information and the order in which the input information bits are arranged.

The circular shifting interleaving may be implemented, using a remnant obtained by dividing the product of the hop parameter and the order information of the input information bits by a circle size.

The circle size may be equal to the size of the input frame.

## BRIEF DESCRIPTION OF THE DRAWINGS

The above objects and advantages of the present invention will become more apparent by describing in detail preferred embodiments thereof with reference to the attached drawings in which:

FIG. 1 is a block diagram of a conventional parallel concatenated recursive systematic encoder;

FIG. 2 is a block diagram of a conventional serial concatenated recursive systematic encoder;

FIG. 3 is a block diagram of a conventional parallel concatenated recursive systematic decoder;

FIG. 4 is a block diagram of a conventional serial concatenated recursive systematic decoder;

FIG. 5 is a block diagram of a concatenated recursive systematic encoder according to a first embodiment of the present invention;

FIG. 6 is a block diagram of a concatenated recursive systematic encoder according to a second embodiment of the present invention;

FIG. 7 is a block diagram of a diagonal interleaver in the turbo encoder according to the first embodiment of the present invention;

FIG. 8 is a flowchart showing a first diagonal interleaving operation in the diagonal interleaver of FIG. 7;

FIG. 9 is a block diagram of a circular shifting interleaver in the turbo encoder according to the second embodiment of the present invention;

FIG. 10 is a flowchart showing a first circular shifting interleaving operation in the circular shifting interleaver of FIG. 9;

FIG. 11 is a flowchart showing a second circular shifting interleaving operation in the interleave shown in FIG. 7;

FIG. 12 is a graph showing characteristics of a turbo encoder relying on random and block interleavings versus those of the turbo encoder relying on circular shifting interleaving according to the second embodiment of the present invention; and

FIG. 13 is a block diagram of a turbo encoder according to the embodiments of the present invention, referred to for describing tail bit generation and puncturing.

## DETAILED DESCRIPTION OF PREFERRED EMBODIMENTS

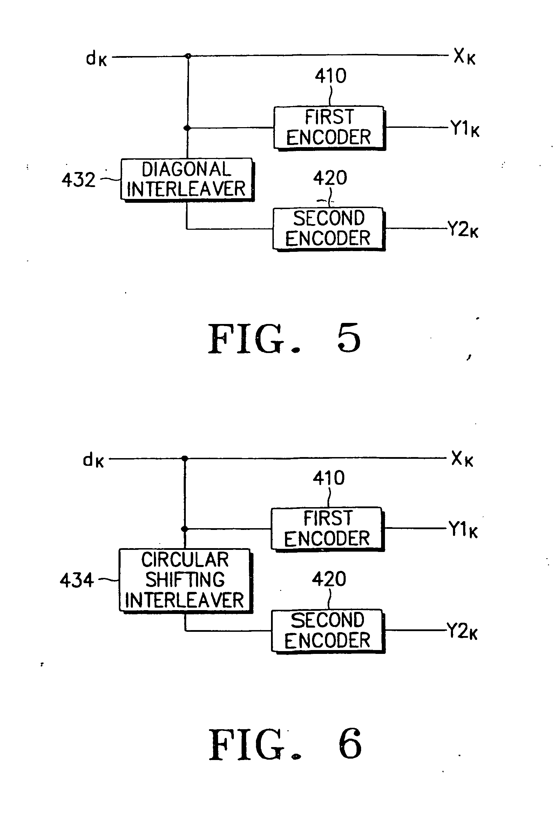

For clarity of description, the embodiments of the present invention are described with reference to a parallel concatenated recursive turbo encoder, other configurations are contemplated such as a serial recursive turbo encoder. FIGS. 5 and 6 are block diagrams of, turbo encoders according to the embodiments of the present invention. Encoders 410 and 420 are component encoders for encoding an input information bit $d_k$ to a parity symbol $Y_k$ similar to the component encoders of FIGS. 1 and 2. An diagonal interleaver 432 and a circular shifting interleaver 434 are a feature of the present invention and will be called an interleaver 430 unless a specific one is referred to.

Referring to FIGS. 5 and 6, information bits $d_k$ are simultaneously fed to the first component encoder 410 and the interleaver 430. The interleaver 430 modifies the order in which the information bits are arranged and, preferably, maximizes a minimum Hamming distance of an encoded output sequence $(X_k, Y_k)$ corresponding to the information bits $d_k$. A data frame input to the channel encoder is variable in length because a CRC (Cyclic Redundancy Check) bit and other control bits are added to data. To forcedly fix the data frame length, dummy bits should be added depending on the difference between frame size and interleaver size. But, since these dummy bits have nothing to do with improvement of system performance, it is desirable to reduce them. Thus, the interleaver 430 provides excellent performance and reliable operation regardless of a variation in frame size-associated parameters.

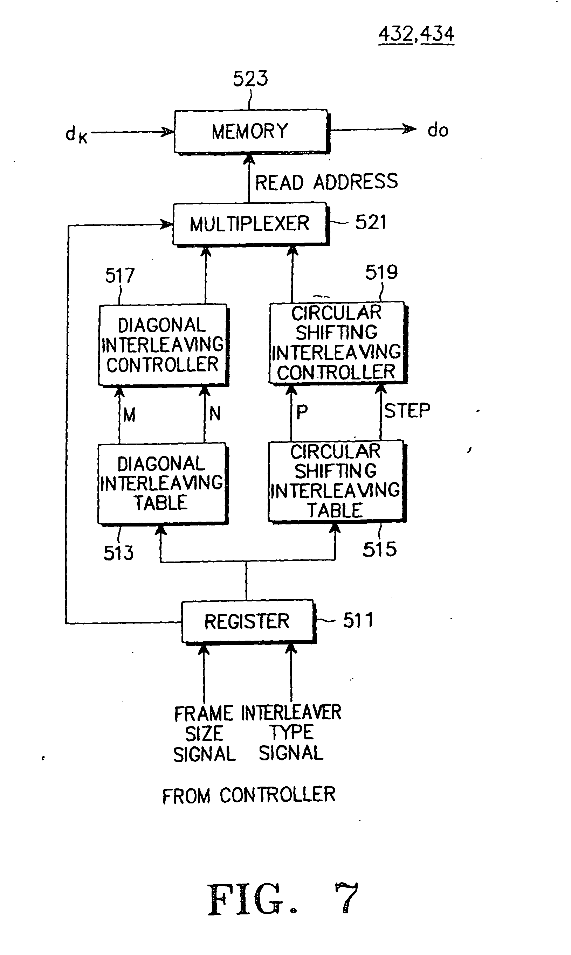

FIG. 7 is a block diagram of the diagonal interleaver 432 and the circular shifting interleaver 434 shown in FIGS. 5 and 6, respectively. Both the diagonal and circular shifting interleavers 432 and 434 analyse their corresponding variable frame sizes upon receipt of information bits and perform an optimum interleaving on the input information bits by interleaver related parameters received from a system controller according to the frame size analysis results. The diagonal interleaver 432 and the circular shifting interleaver 434 are combined into one in description of the embodiments of the present invention, however, a turbo encoder may specifically employ either diagonal interleaving or circular shifting interleaving, separately. Hereinbelow, the diagonal interleaver 432 and the circular shifting interleaver 434 are referred to as the interleaver 430.

Referring to FIG. 7, a register 511 stores a frame size signal and an interleaver type signal received from a system controller (not shown). A diagonal interleaving table 513 stores the numbers M and N of columns and rows in a matrix allowing optimum diagonal interleaving characteristics with respect to frame size during diagonal interleaving. That is, it stores measured MxN values which enable optimum diagonal interleaving of information bits with a variable frame size. The diagonal interleaving table 513 outputs an MxN value corresponding to the frame size signal received from the register 511. A diagonal interleaving controller 517 receives the MxN value from the diagonal interleaving table 513 and generates a read address for interleaving the information bits in a designated interleaving method.

A circular shifting interleaving table 515 stores hop parameters P and step parameters STEP allowing optimum circular shifting interleaving characteristics with respect to the frame size of the information bits in the case of circular shift interleaving. The hop parameters P and the step Parameters STEP are empirically measured. The circular shifting interleaving table 515 outputs parameters P and STEP corresponding to the frame size signal received from the register 511. A circular shifting interleaving controller 519 receives the parameters P and STEP from the circular shifting interleaving table 515 and generates a read address for interleaving the information bits in a designated circular shifting interleaving method. A multiplexer 521 receives the read addresses from the diagonal interleaving controller 517 and the circular shifting interleaving controller 519 and selects on of them in accordance with the interleaver type signal received from the register 511. A memory 523 receives the information bits sequentially and outputs the information bits stored at the read address received form the multiplexer 521 in an interleaved order. The memory 523 is designed to be large enough to accommodate information bits with a maximum variable frame size.

For a structure with only the diagonal interleaver 432 in FIG. 7, the register 511, the diagonal interleaving table 513, the diagonal interleaving controller 517, and the memory 523 are included. On the other hand, for a structure with only the circular shifting interleaver 434 in FIG. 7, the register 511, the circular shifting interleaving table 515, the circular shifting interleaving controller 519, and the memory 523 are included. Both the cases do not need the multiplexer 521 and the interleaver type signal if only one typed of interleaving is employed.

The diagonal interleaving table 513 and the circular shifting interleaving table 515 may be composed of a memory like a ROM or a RAM, or logical devices in combination. The diagonal interleaving controller 517 and the circular shifting interleaving controller 519 can be realized, using logical devices in combination or a digital signal processor.

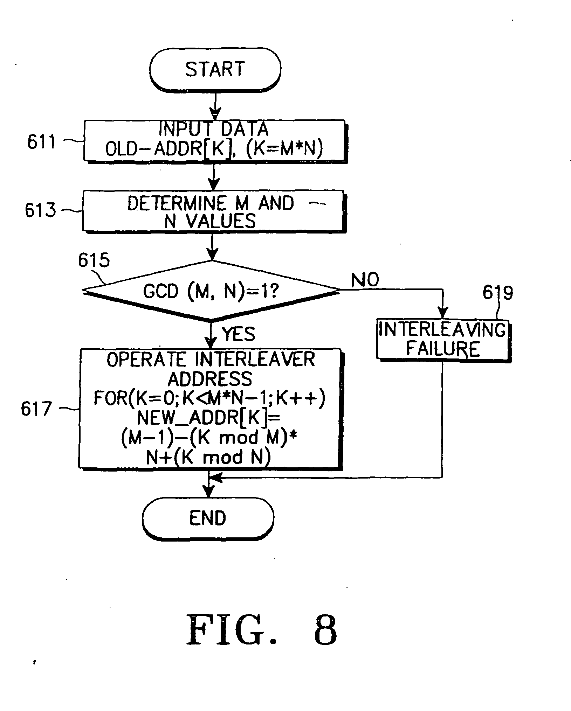

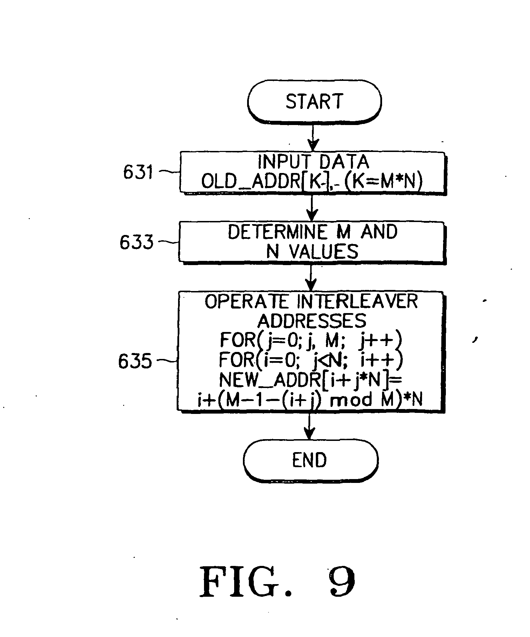

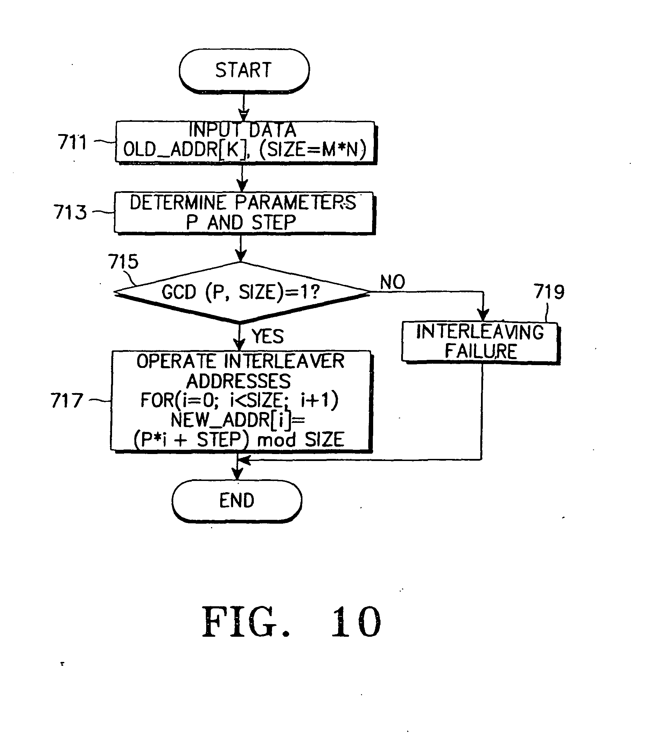

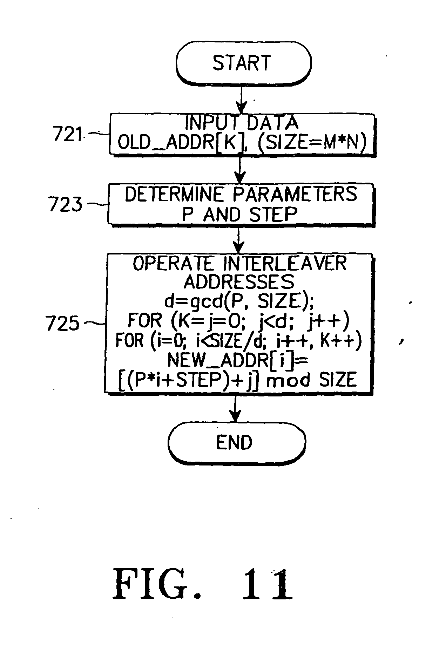

FIGS. 8 and 9 are flowcharts of exemplary diagonal interleavings, and FIGS. 10 and 11 are flowcharts of exemplary circular shifting interleavings. An interleaver which shall be described below, by way of example, has an input buffer.

Referring to the structure of the interleaver 430 shown in FIG. 7, first to third diagonal interleaving operations will be described hereinbelow.

FIG. 8 is a flowchart of the first diagonal interleaving operation. In FIG. 8, the first diagonal interleaving includes a process of reordering an input bit sequence in an MxN matrix. For the first diagonal interleaving, upon receipt of information bits $d_k$, the information bits are stored at addresses old_addr[k] for sequentially storing the information bits in the memory 523 (FIG. 7) and the data frame size k is determined, in step 611. Then, the column and row parameters MxN of the data frame for diagonal interleaving is determined in step 613. That is, to implement diagonal interleaving, the MxN value is designated from the diagonal interleaving table on the basis of the input frame data size k. A plurality of MxN values may be stored in a look-up table to be selected according to the input frame size k. Alternatively, an optimum MxN may be calculated according to the input frame size k. In step 615, it is determined whether the greatest common divisor (GCD) of M and N is 1. When the GCD of M and N is 1, first diagonal interleaving addresses are operated as follows, in step 617.

$$for\ (k = 0;\ k < M * N-1;\ k + +)$$

$$new\ addr[k] = (M - 1 - (k\ mod\ N)) * N + (k\ mod\ N)\ .\ .\ .\ .\ .\ (1)$$

Following the designation of the addresses in an output buffer as in equation (1), the input information bits stored in the input buffer are interleaved and stored in the output buffer.

If the GCD of M and N is not 1, that is, [GCD (M, N) ≠ 1] in step 615, if is determined that the interleaving fails in step 619 and the procedure is terminated.

In the first diagonal interleaving, assuming that a data sequence with M = 6 and N = 5 stored in old_addr[k] is {0 1 2 3 4 5 6 7 8 9 10 11 12 13 14 15 16 17 18 19 20 21 22 23 24 25 26 27 28 29}, a first diagonal interleaver output sequence stored in new_addr[k] of the output buffer is {25 21 17 13 9 0 26 22 18 14 5 1 27 23 19 10 6 2 28 24 15 11 7 3 29 20 16 12 8 4}.

The input data and the first diagonal interleaver output are tabulated in MxN matrixes as follows.

[Table 1]

| input sequence (M = 6, N = 5) | | | | | interleaved sequence (M = 6, N = 5) | | | | |
|---|---|---|---|---|---|---|---|---|---|
| 0 | 1 | 2 | 3 | 4 | 25 | 21 | 17 | 13 | 9 |
| 5 | 6 | 7 | 8 | 9 | 0 | 26 | 22 | 18 | 14 |
| 10 | 11 | 12 | 13 | 14 | 5 | 1 | 27 | 23 | 19 |
| 15 | 16 | 17 | 18 | 19 | 10 | 6 | 2 | 28 | 24 |
| 20 | 21 | 22 | 23 | 24 | 15 | 11 | 7 | 3 | 29 |
| 25 | 26 | 27 | 28 | 29 | 20 | 16 | 12 | 8 | 4 |

However, the above first diagonal interleaving is viable only when the GCD of M and N is 1. When the GCD (M, N) ≠ 1, for example, M = 6 and N = 6, the first diagonal interleaving is impossible and the same data is overwritten as shown in table 2.

[Table 2]

| input sequence (M = 6, N = 6) | | | | | | interleaved sequence (M = 6, N = 6) | | | | | |
|---|---|---|---|---|---|---|---|---|---|---|---|
| 0 | 1 | 2 | 3 | 4 | 5 | 30 | 25 | 20 | 15 | 10 | 5 |
| 6 | 7 | 8 | 9 | 10 | 11 | 30 | 25 | 20 | 15 | 10 | 5 |
| 12 | 13 | 14 | 15 | 16 | 17 | 30 | 25 | 20 | 15 | 10 | 5 |
| 18 | 19 | 20 | 21 | 22 | 23 | 30 | 25 | 20 | 15 | 10 | 5 |
| 24 | 25 | 26 | 27 | 28 | 29 | 30 | 25 | 20 | 15 | 10 | 5 |
| 30 | 31 | 32 | 33 | 34 | 35 | 30 | 25 | 20 | 15 | 10 | 5 |

Second and third diagonal interleavings include a process for permuting an input information bit sequence expressed in an MxN matrix and enable input data to be interleaved regardless of the GCD (M, N) = 1 or ≠ 1.

FIG. 9 is a flowchart of the second diagonal interleaving operation. Referring to FIG. 9, the second diagonal interleaving reorders input bits in an MxN matrix and is applicable to both of cases where the GCD (M, N) = 1 and where the GCD (M, N) ≠ 1. In the second diagonal interleaving, upon input of the information bits $d_k$, the information input bits are stored in addresses old_addr [k] and the frame size k is determined, in step 631. A column and row parameter (MxN) for diagonal interleaving is determined in step 633. In step 635, second diagonal interleaving addresses are operated by

$$for\ (j = 0;\ j < M;\ j + +)$$

$$for\ (i = 0;\ i < N;\ i + +)$$

$$new\ addr[i + j + N] = i + (M - 1 - (i + j)\ mod\ M) * N\ .$$

(2)

where and $i$ and $j$ increment frame location.

Following the designation of the addresses of the output buffer as in equation (2), the information bits stored in the input buffer are interleaved and stored in the output buffer.

The second diagonal interleaved output corresponding to an input sequence with M = 6, N = 5, and the GCD

EP 1 601 109 B1

(M, N) = 1 is shown in table 3.

[Table 3]

| input sequence (M = 6, N = 5) | | | | | interleaved sequence (M = 6, N = 5) | | | | |
|---|---|---|---|---|---|---|---|---|---|
| 0 | 1 | 2 | 3 | 4 | 25 | 21 | 17 | 13 | 9 |
| 5 | 6 | 7 | 8 | 9 | 20 | 16 | 12 | 8 | 4 |
| 10 | 11 | 12 | 13 | 14 | 15 | 11 | 7 | 3 | 29 |
| 15 | 16 | 17 | 18 | 19 | 10 | 6 | 2 | 28 | 24 |
| 20 | 21 | 22 | 23 | 24 | 5 | 1 | 27 | 23 | 19 |
| 25 | 26 | 27 | 28 | 29 | 0 | 26 | 22 | 18 | 14 |

In addition, an input sequence with M = 6, N = 6, and the GCD (M, N) ≠ 1 is interleaved as shown in

[Table 4]

| input sequence (M = 6, N = 6) | | | | | | interleaved sequence (M = 6, N = 6) | | | | | |
|---|---|---|---|---|---|---|---|---|---|---|---|
| 0 | 1 | 2 | 3 | 4 | 5 | 30 | 25 | 20 | 15 | 10 | 5 |
| 6 | 7 | 8 | 9 | 10 | 11 | 24 | 29 | 14 | 9 | 4 | 35 |
| 12 | 13 | 14 | 15 | 16 | 17 | 18 | 13 | 8 | 3 | 34 | 29 |
| 18 | 19 | 20 | 21 | 22 | 23 | 12 | 7 | 2 | 33 | 28 | 23 |
| 24 | 25 | 26 | 27 | 28 | 29 | 6 | 1 | 32 | 27 | 22 | 17 |
| 30 | 31 | 32 | 33 | 34 | 35 | 0 | 31 | 26 | 21 | 16 | 11 |

In the third diagonal interleaving, the diagonal interleaving controller 517 can be implemented by

$$for\ (j = 0;\ j < M;\ j + +)$$

$$for\ (i = 0;\ i < N;\ i + +)$$

$$new\ addr\ [i + j + N] = i + ((i + j)\ mod\ M) * N\ .\ .\ .\ .\ .\ (3)$$

An input sequence is stored at addresses of a mapped memory and then sequentially read by columns or rows by the diagonal interleaver 432. Otherwise, the input sequence is sequentially stored in the memory by columns or rows and read from an address bit by bit by the diagonal interleaver 432.

Deinterleaving is implemented in an order reverse to that of interleaving input data.

FIG. 10 is a flowchart of a first circular interleaving implemented by the circular shifting interleaver 434. The first circular shifting interleaving operation is a data reordering procedure in a predetermined interval, considering an input sequence as a circle. The first circular shifting interleaving operation can interleave an input sequence regardless of its length.

Referring to FIG. 10, input information bits $d_k$ are stored at addresses old_addr [k] of an input buffer, and frame size is determined in step 711. Parameters P and STEP are determined in step 713. Here, P is a hop interval parameter determining the performance of a circular shifting interleaver and thus empirically obtained to achieve an optimum effect. In addition, STEP is a parameter for shifting data from a location hopped by P to the left or right and has an integer value. Then, it is determined whether the GCD of P and SIZE is 1 in step 715. When the GCD (P, SIZE) = 1, first circular shifting interleaving addresses are computed, in step 717, by

$$for\ (i = 0;\ i < SIZE;\ i + +)$$

$$new\ addr[i] = (p * i + STEP)\ mod\ SIZE\ .\ .\ .\ .\ .\ (4)$$

where i is a parameter representative of the frame size of the input data or less than that of the input data frame size,

10

ranging from zero to SIZE, that is, the number of addresses, SIZE is a frame size, p is a natural number satisfying the GCD (SIZE, p) = 1, and STEP is an integer and indicative of a starting point.

For example, the first circular shifting interleaved output, stored in new_addr[k] of the buffer, corresponding to an input sequence with SIZE = 30 stored in new_addr[k] of the input buffer, that is, {0 1 2 3 4 5 6 7 8 9 10 11 12 13 14 15 16 17 18 19 20 21 22 23 24 25 26 27 28 29} is {0 11 22 3 14 25 6 17 28 9 20 1 12 23 4 15 26 7 18 29 10 21 2 13 24 5 16 27 8 19} if P = 11 and STEP = 0. The input sequence and the first circular shifting interleaved output sequence are tabulated as in

[Table 5]

| input sequence (M = 6, N = 5) | | | | | interleaved sequence (M=6, N=5, p=11) | | | | |
|---|---|---|---|---|---|---|---|---|---|
| 0 | 1 | 2 | 3 | 4 | 0 | 11 | 22 | 3 | 14 |
| 5 | 6 | 7 | 8 | 9 | 25 | 6 | 17 | 28 | 9 |
| 10 | 11 | 12 | 13 | 14 | 20 | 1 | 12 | 23 | 4 |
| 15 | 16 | 17 | 18 | 19 | 15 | 26 | 7 | 18 | 29 |
| 20 | 21 | 22 | 23 | 24 | 10 | 21 | 2 | 13 | 24 |
| 25 | 26 | 27 | 28 | 29 | 5 | 16 | 27 | 8 | 19 |

However, with the GCD (SIZE, p) ≠ 1 and p = 6, the first circular shifting interleaving is not viable because the same data is overwritten.

Assuming that SIZE = 30 for an input sequence stored in a sequential address old_addr[k] of an initial memory, P = 11, and STEP = 0, a corresponding interleaved output resulting from the first circular shifting interleaving of FIG. 10 is expressed in an MxN matrix as shown below.

[Table 6]

| input sequence (M = 6, N = 5) | | | | | interleaved sequence (M=6, N=5, p=6) | | | | |
|---|---|---|---|---|---|---|---|---|---|
| 0 | 1 | 2 | 3 | 4 | 0 | 6 | 12 | 18 | 24 |
| 5 | 6 | 7 | 8 | 9 | 0 | 6 | 12 | 18 | 24 |
| 10 | 11 | 12 | 13 | 14 | 0 | 6 | 12 | 18 | 24 |
| 15 | 16 | 17 | 18 | 19 | 0 | 6 | 12 | 18 | 24 |
| 20 | 21 | 22 | 23 | 24 | 0 | 6 | 12 | 18 | 24 |
| 25 | 26 | 27 | 28 | 29 | 0 | 6 | 12 | 18 | 24 |

A second circular interleaving scheme includes enabling interleaving of the case with the GCD (SIZE, p) ≠ 1, as shown in FIG. 11. The second circular shifting interleaving is a data reordering procedure in which an input sequence is viewed as a matrix of d x SIZE/d, rows are first circular shifting interleaved, and columns are block interleaved.

FIG. 11 is a flowchart of the second circular shifting interleaving which is applicable regardless of the GCD (SIZE, p) = 1 or ≠ 1. In the second circular shifting interleaving operation, input information bits are stored in a sequential address old_addr[k] of a memory and size is determined, in step 721. Here, SIZE is a parameter indicative of the size of input data. Parameters P and STEP for circular shifting interleaving are determined in step 723. In step 725, second circular shifting interleaving addresses are achieved by equation (5):

$$d = GCD \ (P, \ SIZE);$$

$$for \ (k - j = 0; j < d; j + +)$$

$$for \ (addr[k] = ((P * i + STEP) + j) \ mod \ SIZE \ . \ . \ . \ . \ . \ (5)$$

where i and k are between 0 to SIZE, j is an address parameter, ranging from 0 to d, P is a hop parameter for implementing circular shifting interleaving, and STEP is a parameter determining a start point by shifting data placed in a location set by P to the left or right.

From equation (5), (P x i + STEP) represents a circular shifting interleaving operation and j indicates a block interleaving operation. SIZE is the size of the input data, p is a natural number, and STEP is an integer.

With SIZE = 30 and p = 11, a second circular shifting interleaved output is expressed in an M x N matrix as

[Table 7]

| input sequence (M = 6, N = 5) | | | | | interleaved sequence (M=6, N=5, p=11) | | | | |
|---|---|---|---|---|---|---|---|---|---|
| 0 | 1 | 2 | 3 | 4 | 0 | 11 | 22 | 3 | 14 |
| 5 | 6 | 7 | 8 | 9 | 25 | 6 | 17 | 28 | 9 |
| 10 | 11 | 12 | 13 | 14 | 20 | 1 | 12 | 23 | 4 |
| 15 | 16 | 17 | 18 | 19 | 15 | 26 | 7 | 18 | 29 |
| 20 | 21 | 22 | 23 | 24 | 10 | 21 | 2 | 13 | 24 |
| 25 | 26 | 27 | 28 | 29 | 5 | 16 | 27 | 8 | 19 |

which is the same as that of table 6. Yet, with the GCD (SIZE, p) ≠ 1,

[Table 8]

| input sequence (M = 6, N = 5) | | | | | interleaved sequence (M=6, N=5, p=15) | | | | |
|---|---|---|---|---|---|---|---|---|---|
| 0 | 1 | 2 | 3 | 4 | 0 | 15 | 1 | 16 | 2 |
| 5 | 6 | 7 | 8 | 9 | 17 | 3 | 18 | 4 | 19 |
| 10 | 11 | 12 | 13 | 14 | 5 | 20 | 6 | 21 | 7 |
| 15 | 16 | 17 | 18 | 19 | 22 | 8 | 23 | 9 | 24 |
| 20 | 21 | 22 | 23 | 24 | 10 | 25 | 11 | 26 | 12 |
| 25 | 26 | 27 | 28 | 29 | 27 | 13 | 28 | 14 | 29 |

After the input sequence is stored at addresses of a mapped memory, the data is sequentially read by columns or rows by the circular shifting interleaver. Otherwise, the input sequence is sequentially stored in the memory by columns or rows and then read from the addresses bit by bit.

Deinterleaving can be implemented in an order reverse to that of interleaving input data.

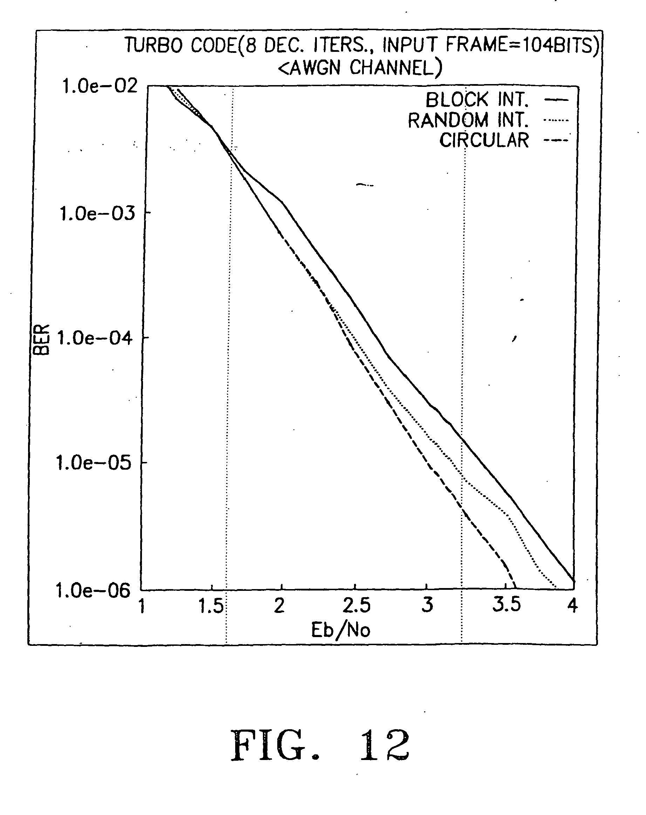

FIG. 12 is a graph showing the performance of the circular shifting interleaver in a parallel concatenated turbo encoder according to the second embodiment of the present invention. Widely used block and random interleavers are compared with the circular shifting interleaver in terms of BER under the conditions of a component code with K=3, an input 104-bit frame, eight iterative decodings, BPSK (Bi-Phase Shift Key) modulation, and AWGN (Additive White Gaussian Noise). As is noted from FIG. 12, Eb/No of the circular shifting interleaver is 3dB, while that of the block interleaver is 3.4dB, under a $10^{-5}$ BER. Thus, it is inferred that the circular shifting interleaver is superior to the block interleaver in performance by about 0.4dB.

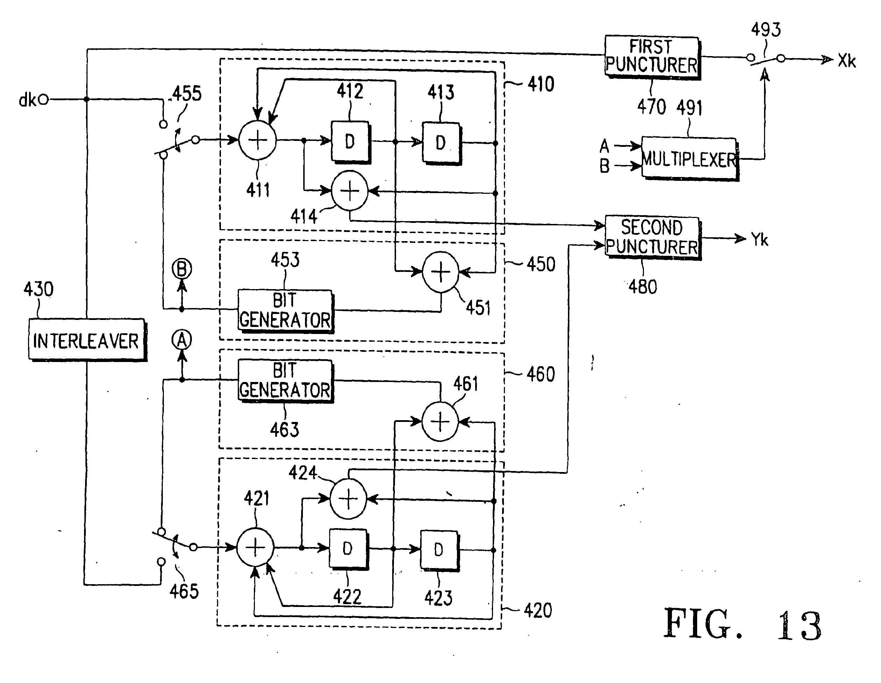

FIG. 13 is a block diagram of a turbo encoder according to the embodiments of the present invention.

Referring to FIG. 13, the first component encoder 410 encodes input information bits with K = 3, for example. The interleaver 430 interleaves the information bits in a predetermined method to thereby modify the order of the information bits. The interleaver 430 can be constituted as shown in FIG. 7. In this case, it may implement one of the first to third diagonal interleavings and the first to third circular shifting interleavings. The second component encoder 420 encodes the output of the interleaver 430 with K = 3, for example.

A first tail bit generator 450 includes a first switch 455 connected to an input port of the first component encoder 410, an exclusive OR gate 451 for performing an exclusive OR operation on outputs of memories 412 and 413 of the first component encoder 410, and a bit generator 453 for generating a signal for terminating frames according to the output of the exclusive OR gate 451, and applying the signal to the first switch 455. In the first tail bit generator 450, the first switch 455 is connected to the first component encoder 410 upon termination of a frame and a frame termination signal is generated. A second tail bit generator 460 includes a second switch 465 connected to an input port of the second component encoder 420, an exclusive OR gate 461 for performing an exclusive OR operation on outputs of memory devices 422 and 423 of the second component encoder 420, and a bit generator 463 according to the output of the exclusive OR gate 461, generating a frame termination signal, and applying the signal to the second switch 465. In the second tail bit generator 460, the second switch 465 is connected to the second component encoder 420 upon termination of a frame and a frame termination signal is generated.

A first puncturer 470 punctures information bits. A second puncturer 480 punctures encoded data received from the first and second component encoders 410 and 420. The first and second puncturers 470 and 480 serve to adjust a data transmission rate. A multiplexer 491 multiplexes the outputs of the bit generators 453 and 463. A third switch 493 switches tail bits received from the multiplexer 491 to a transmission channel upon termination of a frame.

The first and second tail bit generators 450 and 460 generate tail bits for terminating the operations of the first and second component encoders 410 and 420, respectively. The first and second puncturers 470 and 480 function to adjust a transmission rate to an acceptable level.

Referring to FIG. 13, a turbo code has tail bits for terminating the component encoders 410 and 420. Here, since the component codes of the turbo code is systematic, the memories 412 and 413, and 422 and 423 of the component encoders 410 and 420 are not initialized even with input of consecutive zeroes as in a non-systematic convolutional code. To set values in a memory nearest to the input to zeroes, the first and second component encoders 410 and 420 input the sum of fed-back values to the memories by use of the tail bit generators. Therefore, the turbo encoder requires tail bits as many as memories of each component encoder. The first and second switches 455 and 465 are switched upon generation of tail bits. Then, parity bits generated from tail bits are applied from the first and second component encoders 410 and 420 to the second puncturer 480, and tail bits generated from the tail bit generators are switched by the third switch 493 to be output as information bits $X_k$.

It is desirable to set a transmission rate to a power of 2 in order to reduce hardware complexity. However, the 384kbps transmission rate cannot be a power of 2 using a turbo code with a code rate of 1/2. In this case, the 1/2 turbo code is punctured to a 3/8 turbo code. Especially, in the case of 144kbps, the 1/2 turbo code is punctured to be a 9/16 turbo code. 9/16 puncturing matrixes are exemplarily shown in

[Table 9]

| | |
|---|---|
| information bits | 1111111111111111 |
| RSC1 | 1001010010100010010 |
| RSC2 | 0100100101001010001 |

[Table 10]

| | |
|---|---|
| information bits | 1110111101110111110 |
| RSC1 | 101010101010101010 |
| RSC2 | 010101010101010101 |

In tables 9 and 10, information bits are $d_k$, applied to the first puncturer 470, and RSC1 are parity bits applied from the first component encoder 410 to the second puncturer 480. Here, table 9 exemplarily shows puncturing of parity bits output from the component encoders 410 and 420. In this case, there are several consecutive zeroes corresponding to parity bits. That is, when the parity bits are punctured to adjust a transmission rate, zeroes successively appear as indicated by underlines in table 9. However, due to two memories in each of the component encoders 410 and 420, serious errors can be generated unless two or more parity bits are consecutively transmitted. Therefore, the information bits are punctured as shown in table 10 in the present invention. Table 10 shows a 9/16 puncturing matrix different from that of table 9 in that two or more parity bits are successively transmitted. Yet, the performance of the turbo code gets better as the number of iterative decodings increases.

According to the present invention as described above, a turbo code, which was unacceptable for voice and data transmission in a communication system due to time delay, can find its application in voice and data transmission with the introduction of an interleaver having a reduced size and showing excellent performance with respect to the turbo code in a turbo encoder. Furthermore, the interleaver having excellent performance reduces the state number of a component encoder in the turbo encoder, thereby decreasing the complexity of a decoder, in turn. Also, in accordance with one embodiment f the present invention as described above, a variety of encoding rates can be provided by puncturing the input information.

While the present invention has been described in detail with reference to the specific embodiments, they are mere exemplary applications. Thus, it is to be clearly understood that many variations can be made by one skilled in the art within the scope of the present invention as set forth by the appended claims.

**Claims**

**1.** A turbo encoder for encoding input information bits, comprising:

a first component encoder (410) for encoding the input information bits in a frame to generate first parity bits;
an interleaver (430) for interleaving the input information bits, and
a second component encoder (420) for encoding the interleaved input information bits to generate second parity bits,
**characterized by**
a first tail bit generator (450) separate from the first component encoder (410) for generating first tail bits being equal to fed-back values of the first component encoder (410) for terminating the first component encoder, said first tail bit generator comprising an X-OR means;
a second tail bit generator (460) separate from the second component encoder (420) for generating second tail bits being equal to fed-back values of the second component encoder (420) for terminating the second component encoder, said second tail bit generator comprising an X-OR means;
a first switch (455) for switching the fed-back values of the first component encoder (410) to the first component encoder as the first tail bits at the end of the frame, and
a second switch (465) for switching the fed-back values of the second component encoder (420) to the second component encoder as the second tail bits at the end of the frame,

wherein each of the component encoder (410, 420) requires tail bits as many as memories of the component encoder being arranged for coding input information bits of variable frame sizes, wherein the component encoders (410, 420) output one information bit and two parity bits in response to providing each of the information bits to the component encoder and output two tail bits and two parity bits in response to providing each of the first and second tail bits to the component encoder (410, 420).

2. The turbo coder according to claim 1, further comprising:

   a puncturer (480) for puncturing one of the first parity or the second parity bits at a time.

3. The turbo coder according to claim 1, further comprising:

   a multiplexer (491) for multiplexing the first tail bits and the second tail bits.

4. The turbo coder according to claim 1, wherein the first component encoder (410) encodes the input information bits or the first tail bits to generate the first parity bits, and the second component encoder (420) encodes the interleaved input information bits or the second tail bits to generate the second parity bits.

5. The turbo coder according to claim 4, wherein the tail bits are fed to each component encoder (410, 420) after all of the input information bits are encoded.

6. A channel encoding method for use in a channel encoder having a first component encoder (410) and a second component encoder (420),
   **characterized by**
   comprising the steps of:

   receiving input information bits;
   generating first parity bits of the input information bits and first fed-back values by the first component encoder (410);
   interleaving the input information bits adaptively according to the number of input information bits;
   generating second parity bits of the interleaved input information bits and second fed-back values by the second component encoder (420);
   generating by a first tail bit generator (450) separate from the first component encoder (410) and comprising an X-OR means (451) first tail bits and by a second tail bit generator (460) separate from the second component encoder (420) and comprising an X-OR means (461) second tail bits being equal to the first and second fed-back values, respectively for terminating memories in the first and second component encoders (410, 420) and feeding the tail bits to the first and second component encoder, and
   puncturing the outputs of the component encoders (410, 420) to adjust a transmission rate, wherein each of the component encoders (410, 420) requires tail bits as many as memories of the component encoder being arranged for encoding input information bits of variable frame sizes, wherein one information bit and two parity bits are outputted in response to providing each of the information bits to the component encoder and two tail bits and two parity bits are outputted in response to providing each of the first and second tail bits to the component encoders (410, 420).

7. The channel encoding method according to claim 6, wherein the tail bits are fed to each component encoder (410, 420) after all of the input information bits are encoded.

8. The channel encoding method according to claim 6, comprising the further step of:

multiplexing the first tail bits and the second tail bits.

9. The turbo encoder according to claim 1, further comprising:

an input for receiving variable size of input information bits and an output for outputting the information bits;
a puncturer (480) for puncturing a part of first and second parity bits to adjust data transmission rate, wherein a number of tail bits identical to the number of delay memories are generated for terminating the component encoder (410, 420) and the tail bits are transmitted on the output of the information bits;
wherein the first component encoder (420) has a predetermined number of delay memories for encoding the input information bits received from the input and generating first parity bits and
the interleaver (430) interleaves the input information bits received from the input and the second component encoder (420) has a predetermined number of delay memories for encoding the interleaved information bits and generating second parity bits.

10. The channel encoding device according to claim 9, wherein the input information and the parity bits are separately punctured.

11. The channel encoding device according to claim 9, wherein not all of the input information, the first parity, and the second parity bits are punctured.

12. The channel encoding device according to claim 9, wherein not all of the first parity and the second parity bits are punctured.


**Patentansprüche**

1. Turbocodierer zum Codieren von Eingangs-Informationsbits, der umfasst:

einen ersten Teilcodierer (410) zum Codieren der Eingangs-Informationsbits in einem Rahmen, um erste Paritätsbits zu erzeugen;
einen Interleaver (430) für Interleaving der Eingangs-Informationsbits, und
einen zweiten Teilcodierer (420) zum Codieren der Interleaving unterzogenen Eingangs-Informationsbits, um zweite Paritätsbits zu erzeugen,
**gekennzeichnet durch**
einen ersten Endbit-Generator (450) separat von dem ersten Teilcodierer (410) zum Erzeugen erster Endbits, die Rückführwerten des ersten Teilcodierers (410) gleich sind, um den ersten Teilcodierer abzuschließen, wobei der erste Endbit-Generator eine X-OR-Einrichtung umfasst;
einen zweiten Endbit-Generator (460) separat von dem zweiten Teilcodierer (420) zum Erzeugen zweiter Endbits, die Rückführwerten des zweiten Teilcodierers (420) gleich sind, um den zweiten Teilcodierer abzuschließen, wobei der zweite Endbit-Generator eine X-OR-Einrichtung umfasst;
eine erste Schalteinrichtung (455) zum Schalten der Rückführwerte des ersten Teilcodierers (410) zu dem ersten Teilcodierer als die ersten Endbits am Ende des Rahmens, und
eine zweite Schalteinrichtung (465) zum Schalten der Rückführwerte des zweiten Teilcodierers (420) zu dem zweiten Teilcodierer als die zweiten Endbits am Ende des Rahmens,

wobei jeder der Teilcodierer (410, 420) so viele Endbits wie Speicher des Teilcodierers erfordert, die zum Codieren von Eingangs-Informationsbits variabler Rahmengrößen eingerichtet sind, die Teilcodierer (410, 420) ein Informationsbit und zwei Paritätsbits in Reaktion darauf ausgeben, dass dem Teilcodierer jedes der Informationsbits bereitgestellt wird, und zwei Endbits sowie zwei Paritätsbits in Reaktion darauf ausgeben, dass dem Teilcodierer (410, 420) jedes der ersten und zweiten Endbits bereitgestellt wird.

2. Turbocodierer nach Anspruch 1, der des Weiteren umfasst:

eine Punktiereinrichtung (480) zum Punktieren jeweils des ersten oder des zweiten Paritätsbits.

**3.** Turbocodierer nach Anspruch 1, der des Weiteren umfasst:

ein Multiplexer (491) zum Multiplexieren der ersten Endbits und der zweiten Endbits.

**4.** Turbocodierer nach Anspruch 1, wobei der erste Teilcodierer (410) die Eingangs-Informationsbits oder die ersten Endbits codiert, um die ersten Paritätsbits zu erzeugen, und der zweite Teilcodierer (420) die Interleaving unterzogenen Eingangs-Informationsbits oder die zweiten Endbits codiert, um die zweiten Paritätsbits zu erzeugen.

**5.** Turbocodierer nach Anspruch 4, wobei die Endbits jedem Teilcodierer (410, 420) zugeführt werden, nachdem alle Eingangs-Informationsbits codiert sind.

**6.** Kanalkodierverfahren zum Einsatz in einem Kanalcodierer mit einem ersten Teilcodierer (410) und einem zweiten Teilcodierer (420), **dadurch gekennzeichnet, dass** es die folgenden Schritte umfasst:

Empfangen von Eingangs-Informationsbits;
Erzeugen erster Paritätsbits der Eingangs-Informationsbits und erster Rückführwerte durch den ersten Teilcodierer (410);
adaptives Interleaving der Eingangs-Informationsbits entsprechend der Zahl von Eingangs-Informationsbits;
Erzeugen zweiter Paritätsbits der Interleaving unterzogenen Eingangs-Informationsbits und zweiter Rückführwerte durch den zweiten Teilcodierer (420);
Erzeugen erster Endbits durch einen ersten Endbit-Generator (450), der separat von dem ersten Teilcodierer (410) vorhanden ist und eine X-OR-Einrichtung (451) umfasst, sowie zweiter Endbits, die den ersten bzw. zweiten Rückführwerten gleich sind, durch einen zweiten Endbit-Generator (460), der separat von dem zweiten Teilcodierer (420) vorhanden ist, und eine X-OR-Einrichtung (461) umfasst, um entsprechend Speicher in dem ersten und dem zweiten Teilcodierer (410, 420) abzuschließen und die Endbits dem ersten sowie dem zweiten Teilcodierer zuzuführen, und
Punktieren der Ausgaben der Teilcodierer (410, 420), um eine Senderate zu regulieren, wobei jeder der Teilcodierer (410, 420) so viele Endbits wie Speicher des Teilcodierers erfordert, die zum Codieren von Eingangs-Informationsbits variabler Rahmengrößen angeordnet sind, ein Informationsbit sowie zwei Paritätsbits in Reaktion darauf ausgegeben werden, dass dem Teilcodierer jedes der Informationsbits bereitgestellt wird, und zwei Endbits sowie zwei Paritätsbits in Reaktion darauf ausgegeben werden, dass den Teilcodierern (410, 420) jedes der ersten und zweiten Endbits bereitgestellt wird.

**7.** Kanalkodierverfahren nach Anspruch 6, wobei die Endbits jedem Teilcodierer (410, 420) zugeführt werden, nachdem alle Eingangs-Informationsbits codiert sind.

**8.** Kanalkodierverfahren nach Anspruch 6, den folgenden weiteren Schritt umfasst:

Multiplexieren der ersten Endbits und der zweiten Endbits.

**9.** Turbocodierer nach Anspruch 1, der des Weiteren umfasst:

einen Eingang zum Empfangen von Eingangs-Informationsbit variabler Größe sowie einen Ausgang zum Ausgeben der Informationsbits;
eine Punktiereinrichtung (480) zum Punktieren eines Teils erster und zweiter Paritätsbits, um eine Daten-Senderate zu justieren, wobei eine Anzahl von Endbits, die identisch zur Anzahl von Verzögerungsspeichern ist, erzeugt wird, um den Teilcodierer (410, 420) abzuschließen, und die Endbits an den Ausgang der Informationsbits gesendet werden;
wobei der erste Teilcodierer (420) eine vorgegebene Anzahl von Verzögerungsspeichern aufweist, um die von dem Eingang empfangenen Eingangs-Informationsbits zu codieren und erste Paritätsbits zu erzeugen, und der Interleaver (430) die von dem Eingang empfangenen Eingangs-Informationsbits Interleaving unterzieht und der zweite Teilcodierer (420) eine vorgegebene Anzahl von Verzögerungsspeichern aufweist, um die Interleaving unterzogenen Informationsbits zu codieren und zweite Paritätsbits zu erzeugen.

**10.** Kanalkodiervorrichtung nach Anspruch 9, wobei die Eingangs-Informationsbits und die Paritätsbits separat punktiert werden.

**11.** Kanalkodiervorrichtung nach Anspruch 9, wobei nicht alle Eingangs-Informations-, erste Paritäts- und zweite Paritätsbits punktiert werden.

**12.** Kanalkodiervorrichtung nach Anspruch 9, wobei nicht alle der ersten Paritätsbits und der zweiten Paritätsbits punktiert werden.

**Revendications**

**1.** Encodeur turbo permettant d'encoder des bits d'informations en entrée, comprenant :

un premier encodeur de composants (410) permettant d'encoder les bits d'information en entrée dans une trame afin de générer des premiers bits de parité,
un dispositif d'entrelacement (430) permettant d'entrelacer les bits d'information en entrée, et
un second encodeur de composants (420) permettant d'encoder les bits entrelacés d'information en entrée afin de générer des seconds bits de parité,
**caractérisé par**
un premier générateur de bits d'extrémité (450), séparé du premier encodeur de composants (410), afin de générer des premiers bits d'extrémité égaux à des valeurs en retour du premier encodeur de composants (410) afin de refermer le premier encodeur de composants, ledit premier générateur de bits d'extrémité comprenant une fonction OU EXCLUSIF (X-OR),
un second générateur de bits d'extrémité (460), séparé du second encodeur de composants (420), afin de générer des seconds bits d'extrémité égaux à des valeurs en retour du second encodeur de composants (420) afin de refermer le second encodeur de composants, ledit second générateur de bits d'extrémité comprenant une fonction OU EXCLUSIF (X-OR),
un premier commutateur (455) permettant de commuter les valeurs en retour du premier encodeur de composants (410) sur le premier encodeur de composants comme étant les premiers bits d'extrémité à la fin de la trame, et
un second commutateur (465) permettant de commuter les valeurs en retour du second encodeur de composants (420) sur le second encodeur de composants comme étant les seconds bits d'extrémité à la fin de la trame, chaque encodeur de composants (410, 420) nécessitant autant de bits d'extrémité que de mémoires de l'encodeur de composants, agencées pour encoder les bits d'informations en entrée de tailles de trame variables, les encodeurs de composants (410, 420) fournissant en sortie un bit d'information et deux bits de parité en réponse à la fourniture de chacun des bits d'informations sur l'encodeur de composants et fournissant en sortie deux bits d'extrémité et deux bits de parité en réponse à la fourniture à l'encodeur de composants (410, 420) de chacun des premier et second bits d'extrémité.

**2.** Encodeur turbo selon la revendication 1, comprenant en outre :

un perforateur (480) permettant de perforer l'un du premier bit de parité ou du second bit de parité à un instant donné.

**3.** Encodeur turbo selon la revendication 1, comprenant en outre :

un multiplexeur (491) permettant de multiplexer les premiers bits d'extrémité et les seconds bits d'extrémité.

**4.** Encodeur turbo selon la revendication 1, dans lequel le premier encodeur de composants (410) code les bits d'informations en entrée ou les premiers bits d'extrémité afin de générer les premiers bits de parité, et dans lequel le second encodeur de composants (420) code les bits entrelacés d'information en entrée ou les seconds bits d'extrémité afin de générer les seconds bits de parité.

**5.** Encodeur turbo selon la revendication 4, dans lequel les bits d'extrémité sont introduits vers chaque encodeur de composants (410, 420) après que tous les bits d'informations en entrée ont été codés.

**6.** Procédé d'encodage de canal destiné à être utilisé dans un encodeur de canal possédant un premier encodeur de composants (410) et un second encodeur de composants (420),
**caractérisé en ce qu'**il comprend les étapes consistant à :

recevoir des bits d'informations en entrée,

générer des premiers bits de parité appartenant aux bits d'informations en entrée et des premières valeurs en retour grâce au premier encodeur de composants (410),

entrelacer de façon adaptative les bits d'informations en entrée en fonction du nombre de bits d'informations en entrée,

générer des seconds bits de parité appartenant aux bits entrelacés d'informations en entrée et des secondes valeurs en retour grâce au second encodeur de composants (420),

générer, grâce à un premier générateur de bits d'extrémité (450), séparé du premier encodeur de composants (410) et comprenant une fonction OU EXCLUSIF (X-OR) (451), des premiers bits d'extrémité et, grâce à un second générateur de bits d'extrémité (460) séparé du second encodeur de composants (420) et comprenant une fonction OU EXCLUSIF (X-OR) (461), des seconds bits d'extrémité égaux respectivement aux première et seconde valeurs en retour pour refermer les mémoires dans les premier et second encodeurs de composants (410, 420) et introduire les bits d'extrémité sur le premier et le second encodeur de composants, et

perforer les sorties des encodeurs de composants (410, 420) afin d'ajuster une vitesse d'émission, chacun des encodeurs de composants (410, 420) requérant autant de bits d'extrémité que de mémoires de l'encodeur de composants, agencées pour encoder des bits d'informations en entrée de tailles de trame variables, un bit d'information et deux bits de parité étant fournis en sortie en réponse à la fourniture de chacun des bits d'informations à l'encodeur de composants, et deux bits d'extrémité et deux bits de parité étant fournis en sortie en réponse à la fourniture de chacun des premier et second bits d'extrémité aux encodeurs de composants (410, 420).

7. Procédé d'encodage de canal selon la revendication 6, dans lequel les bits d'extrémité sont introduits vers chaque encodeur de composants (410, 420) après que tous les bits d'informations en entrée ont été codés.

8. Procédé d'encodage de canal selon la revendication 6, comprenant l'étape complémentaire consistant à multiplexer les premiers bits d'extrémité et les seconds bits d'extrémité.

9. Encodeur turbo selon la revendication 1, comprenant en outre :

une entrée permettant de recevoir des bits d'informations de taille variable en entrée ainsi qu'une sortie permettant de fournir les bits d'informations,

un perforateur (480) permettant de perforer une partie de premier et second bits de parité afin d'ajuster la vitesse d'émission des données, dans lequel un certain nombre de bits d'extrémité, identique au nombre de mémoires de retard, est généré pour refermer l'encodeur de composants (410, 420), et dans lequel les bits d'extrémité sont transmis sur la sortie des bits d'informations,

dans lequel le premier encodeur de composants (410) possède un nombre prédéterminé de mémoires de retard permettant d'encoder les bits d'informations en entrée reçus depuis l'entrée et de générer des premiers bits de parité et

le dispositif d'entrelacement (430) entrelace les bits d'informations en entrée reçus depuis l'entrée et le second encodeur de composants (420) possède un nombre prédéterminé de mémoires de retard permettant d'encoder les bits entrelacés d'informations et de générer des seconds bits de parité.

10. Dispositif d'encodage de canal selon la revendication 9, dans lequel les informations d'entrée et les bits de parité sont perforés séparément.

11. Dispositif d'encodage de canal selon la revendication 9, dans lequel la totalité des informations d'entrée, tous les premiers bits de parité et tous les seconds bits de parité ne sont pas perforés.

12. Dispositif d'encodage de canal selon la revendication 9, dans lequel tous les premiers bits de parité et les seconds bits de parité ne sont pas perforés.

(PRIOR ART)

# FIG. 1

(PRIOR ART)

# FIG. 2

(PRIOR ART)
FIG. 3

11 INNER CODE DECODER

12 DEINTERLEAVER

14 OUTER CODE DECODER

13 INTERLEAVER

(PRIOR ART)
# FIG. 4

d_K ——————●—————————————————— X_K

410

FIRST
ENCODER ——— Y1_K

432 — DIAGONAL
INTERLEAVER

420

SECOND
ENCODER ——— Y2_K

# FIG. 5

d_K ——————●—————————————————— X_K

410

FIRST
ENCODER ——— Y1_K

434 — CIRCULAR
SHIFTING
INTERLEAVER

420

SECOND
ENCODER ——— Y2_K

# FIG. 6

432,434

523

$d_K$ ──────▶ | MEMORY | ──────▶ do

READ ADDRESS

| MULTIPLEXER | ─ 521

517

| DIAGONAL INTERLEAVING CONTROLLER |

519

| CIRCULAR SHIFTING INTERLEAVING CONTROLLER |

M    N

P    STEP

| DIAGONAL INTERLEAVING TABLE |

| CIRCULAR SHIFTING INTERLEAVING TABLE |

513

515

| REGISTER | ─ 511

FRAME SIZE SIGNAL

INTERLEAVER TYPE SIGNAL

FROM CONTROLLER

# FIG. 7

START

611 — INPUT DATA
OLD-ADDR[K], (K=M*N)

613 — DETERMINE M AND
N VALUES

615

GCD (M, N)=1? — NO —

YES

617 — OPERATE INTERLEAVER
ADDRESS
FOR(K=0;K<M*N-1;K++)
NEW_ADDR[K]=
(M-1)-(K mod M)*
N+(K mod N)

619

INTERLEAVING
FAILURE

END

# FIG. 8

START

631 — INPUT DATA
OLD_ADDR[K], (K=M*N)

633 — DETERMINE M AND
N VALUES

635 — OPERATE INTERLEAVER
ADDRESSES
FOR(j=0; j, M; j++)
FOR(i=0; j<N; i++)
NEW_ADDR[i+j*N]=
i+(M-1-(i+j) mod M)*N

END

# FIG. 9

START

711 — INPUT DATA
OLD_ADDR[K], (SIZE=M*N)

713 — DETERMINE PARAMETERS
P AND STEP

715

GCD (P, SIZE)=1?

NO

719

INTERLEAVING
FAILURE

YES

717 — OPERATE INTERLEAVER
ADDRESSES
FOR(i=0; i<SIZE; i+1)
NEW_ADDR[i]=
(P*i + STEP) mod SIZE

END

# FIG. 10

```
                    ┌─────────────┐
                    │    START    │
                    └──────┬──────┘
                           │
                           ▼
        ┌──────────────────────────────────────┐
721 ~   │             INPUT DATA                │
        │      OLD_ADDR[K], (SIZE=M*N)           │
        └──────────────────┬───────────────────┘
                           │
                           ▼
        ┌──────────────────────────────────────┐
723 ~   │       DETERMINE PARAMETERS            │
        │             P AND STEP                │
        └──────────────────┬───────────────────┘
                           │
                           ▼
        ┌──────────────────────────────────────┐
        │       OPERATE INTERLEAVER             │
        │             ADDRESSES                 │
        │           d=gcd(P, SIZE);             │
725 ~   │        FOR (K=j=0; j<d; j++)          │
        │     FOR (i=0; i<SIZE/d; i++, K++)     │
        │            NEW_ADDR[i]=               │
        │       [(P*i+STEP)+j] mod SIZE         │
        └──────────────────┬───────────────────┘
                           │
                           ▼
                    ┌─────────────┐
                    │     END     │
                    └─────────────┘
```

# FIG. 11

TURBO CODE(8 DEC. ITERS., INPUT FRAME=104BITS)
<AWGN CHANNEL)

BLOCK INT. ——
RANDOM INT. ········
CIRCULAR ---

FIG. 12

FIG. 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5446747 A

### Non-patent literature cited in the description

- **Benedetto.** *Electronics Letters,* June 1996, vol. 32 (13
- *Proceedings of IEEE Vehicular Technology Conference,* May 1993, 941-944
- *IEEE Transactions on Information Theory,* March 1996, vol. 42 (2), 429-445
- **Divsalar, D. et al.** Turbo Codes for Deep-Space Communications. *TDA Progress Report,* 15 February 1995, vol. 42-120, 29-39
- **Bomer, L. et al.** A CDMA Radio Link with 'Turbo-Decoding': Concept and Performance Evaluation. *6th IEEE symposium and personal, indoor and mobile radio communications PIMRC'1995,* 27 September 1995, vol. 2, 788-793
- **Barbulescu, A.S. et al.** Rate Compatible Turbo Codes. *Electronic Letters, IEE Stevenage,* 30 March 1995, vol. 31 (7), 535-536
- **Berrou, C. et al.** Near Shannon Limit Error - Correcting Coding and Decoding: Turbo-Codes (1). *Proceedings of The International Conference on Communications (ICC) Geneva,* 23 May 1993, vol. 3, 1064-1070